# EUROPEAN PATENT APPLICATION

(11) **EP 4 593 306 A1**
(43) Date of publication of application: **30.07.2025**
(21) Application number: 23916407.2
(22) Date of filing: 28.11.2023
(51) Int. Cl.: H04B 10/079, G01R 31/08, H04N 7/22

(54) **ELECTRONIC DEVICE FOR TRANSMITTING IMAGE DATA AND METHOD FOR CONTROLLING SAME**

(30) Priority: 13.01.2023 KR 20230005404
(71) Applicant: Samsung Electronics Co., Ltd., Suwon-si, Gyeonggi-do 16677 (KR)
(72) Inventor: SEO, Gaewon, Suwon-si Gyeonggi-do 16677 (KR)
(74) Representative: Appleyard Lees IP LLP
(86) International application number: PCT/KR2023/019364
(87) International publication number: WO 2024/150924

(57) **Abstract**

An electronic apparatus and a controlling method thereof are provided. The electronic apparatus includes a first interface connected to a first small form-factor pluggable (SFP) module included in one end of an optical cable, a second interface connected to a second SFP module included in the other end of the optical cable, and one or more processors. The one or more processors are configured to change a level of a voltage of image data to generate test data corresponding to the image data, based on the test data transmitted through the first interface being received through the second interface, identify whether the first and second SFP modules and the optical cable are progressively defective based on the received test data and the image data.

## Description

### [Technical Field]

The present disclosure relates to an electronic apparatus for transmitting image data and a controlling method thereof. More specifically, the present disclosure relates to an electronic apparatus for transmitting image data to a display apparatus using an optical cable connected through an SFP module and a controlling method thereof.

### [Background Art]

The development of display technology has diversified the screen sizes of display apparatuses. In the past, it was possible to produce display apparatuses with only a limited size, but in recent years, it has become possible to produce display apparatuses with large screens, freeing them from the limitations of display sizes. As a result, the use of large-screen display apparatuses is increasing in real life. For example, a digital signage billboard is a large-screen display apparatus that is installed in places with a lot of floating population, such as subway stations and bus stops, and then displays outdoor advertisements through the display apparatus.

Such a large-screen display apparatus receives image data from a separate source apparatus. In this case, the source apparatus and the display apparatus are connected through an optical cable including an SFP module, and the source apparatus transmits image data to the display apparatus through the optical cable. Accordingly, when the optical cable and the SFP module are defective, some data may be missing from the image data transmitted by the source apparatus, and furthermore, the image data itself may not be transmitted. In particular, defects in such an optical cable and SFP module may be caused by long-term use of the optical cable and SFP module in the course of use.

### [Detailed Description of the Disclosure]

### [Technical Solution]

An electronic apparatus according to an embodiment includes a first interface connected to a first small form-factor pluggable (SFP) module included in one end of an optical cable, a second interface connected to a second SFP module included in the other end of the optical cable, and one or more processors. The one or more processors are configured to change a level of a voltage of image data to generate test data corresponding to the image data, and based on the test data transmitted through the first interface being received through the second interface, identify whether the optical cable is progressively defective based on the received test data and the image data.

**A** controlling method of an electronic apparatus according to an embodiment includes changing a level of a voltage of image data to generate test data corresponding to the image data. The controlling method includes transmitting the test data through a first interface connected to a first small form-factor pluggable (SFP) module included in one end of an optical cable. The controlling method includes receiving the test data through a second interface connected to a second SFP module included in the other end of the optical cable. The controlling method includes identifying whether the optical cable is progressively defective based on the received test data and the image data.

A computer instruction, when executed by a processor, causes a controlling method of an electronic apparatus to be performed may be stored in a computer-readable recording medium. The controlling method of the electronic apparatus includes changing a level of a voltage of image data to generate test data corresponding to the image data. The controlling method includes transmitting the test data through a first interface connected to a first small form-factor pluggable (SFP) module included in one end of an optical cable. The controlling method includes receiving the test data through a second interface connected to a second SFP module included in the other end of the optical cable. The controlling method includes identifying whether the optical cable is progressively defective based on the received test data and the image data.

### [Brief Description of Drawings]

FIG. 1 is an exemplary view illustrating an electronic apparatus and a display apparatus that receives image data from the electronic apparatus;
FIG. 2 is a schematic view illustrating an electronic apparatus according to an embodiment;
FIG. 3 is an exemplary view illustrating a connection state between an electronic apparatus and an optical cable according to an embodiment;
FIG. 4 is an exemplary view illustrating test data according to an embodiment;
FIGS. 5A, 5B and 5C are exemplary views illustrating test data according to an embodiment; and
FIG**.** 6 is an exemplary view schematically illustrating a controlling method of an electronic apparatus according to an embodiment.

### [Detailed Description of Embodiments]

The embodiments of the present disclosure may be modified in various ways, and may have various embodiments, so specific embodiments are illustrated in the drawings and described in detail in the detailed description. However, it is to be understood that the disclosure is not limited to specific exemplary embodiments, but include all modifications, equivalents, and/or alternatives according to exemplary embodiments of the disclosure. Throughout the description of the accompanying drawings, similar components may be denoted by similar reference numerals.

In describing the disclosure, when it is decided that a detailed description for the known functions or configurations related to the disclosure may unnecessarily obscure the gist of the disclosure, the detailed description therefor will be omitted.

In addition, the following exemplary embodiments may be modified in several different forms, and the scope of the technical spirit of the disclosure is not limited to the following exemplary embodiments. Rather, these exemplary embodiments make the disclosure thorough and complete, and are provided to completely transfer the spirit of the disclosure to those skilled in the art.

Terms used in the disclosure are used only to describe specific exemplary embodiments rather than limiting the scope of the disclosure. Singular forms are intended to include plural forms unless the context clearly indicates otherwise.

In the disclosure, the expressions "have", "may have", "include" or "may include" used herein indicate existence of corresponding features (e.g., elements such as numeric values, functions, operations, or components), but do not exclude presence of additional features.

In the disclosure, the expressions "A or B", "at least one of A or/and B", or "one or more of A or/and B", and the like may include any and all combinations of one or more of the items listed together. For example, the term "A or B", "at least one of A and B", or "at least one of A or B" may refer to all of the case (1) where at least one A is included, the case (2) where at least one B is included, or the case (3) where both of at least one A and at least one B are included.

Expressions "first", "second", "1st," "2nd," or the like, used in the disclosure may indicate various components regardless of sequence and/or importance of the components, will be used only in order to distinguish one component from the other components, and do not limit the corresponding components.

When it is described that an element (e.g., a first element) is referred to as being "(operatively or communicatively) coupled with/to" or "connected to" another element (e.g., a second element), it should be understood that it may be directly coupled with/to or connected to the other element, or they may be coupled with/to or connected to each other through an intervening element (e.g., a third element).

On the other hand, when an element (e.g., a first element) is referred to as being "directly coupled with/to" or "directly connected to" another element (e.g., a second element), it should be understood that there is no intervening element (e.g., a third element) in-between.

An expression "~configured (or set) to" used in the disclosure may be replaced by an expression, for example, "suitable for," "having the capacity to," "~designed to," "~adapted to," "~made to," or "~capable of" depending on a situation. A term "~configured (or set) to" may not necessarily mean "specifically designed to" in hardware.

Instead, an expression "~an apparatus configured to" may mean that an apparatus "is capable of" together with other apparatuses or components. For example, a "processor configured (or set) to perform A, B, and C" may mean a dedicated processor (e.g., an embedded processor) for performing the corresponding operations or a generic-purpose processor (e.g., a central processing unit (CPU) or an application processor) that may perform the corresponding operations by executing one or more software programs stored in a memory apparatus.

**In** the disclosure, a 'module' or a 'unit' may perform at least one function or operation, and be implemented as hardware or software or be implemented as a combination of hardware and software. In addition, a plurality of 'modules' or a plurality of 'units' may be integrated into at least one module and be implemented as at least one processor except for a 'module' or a 'unit' that needs to be implemented as specific hardware.

Meanwhile, various elements and regions in the drawings are schematically drawn in the drawings. Therefore, the technical concept of the disclosure is not limited by a relative size or spacing drawn in the accompanying drawings.

Hereinafter, one or more embodiments according to the present disclosure will be described in detail with reference to the accompanying drawings so that a person with ordinary knowledge in the technical field to which the present disclosure belongs can easily implement the present disclosure.

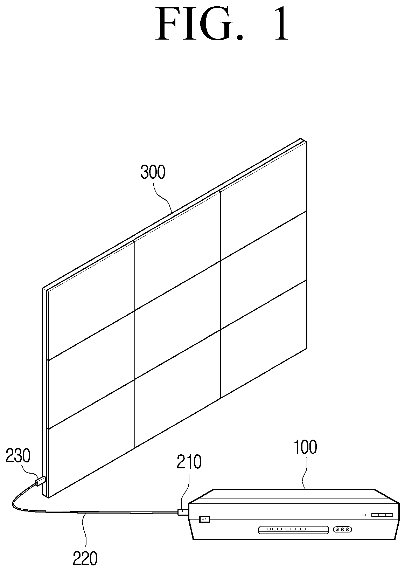

FIG. 1 is an exemplary view illustrating an electronic apparatus and a display apparatus that receives image data from the electronic apparatus.

An electronic apparatus 100 of the present disclosure transmits image data to a display apparatus 300. Upon receiving the image data from the electronic apparatus 100, the display apparatus 300 may display a screen corresponding to the image data. According to an embodiment, the electronic apparatus 100 may be implemented as a source apparatus, a set-top box, or the like.

Referring to FIG. 1, the electronic apparatus 100 and the display apparatus 300 may be connected through an optical cable 220 to transmit and receive image data. Specifically, the electronic apparatus 100 may be connected to one end of the optical cable 220 through SFP modules 210, 230. In this case, the display apparatus 300 may be connected to the other end of the optical cable 220 through another SFP module. Accordingly, the electronic apparatus 100 and the display apparatus 300 may transmit and receive various data including image data through the optical cable 220.

Meanwhile, since the electronic apparatus 100 and the display apparatus 300 are connected through the SFP modules 210, 230 and the optical cable 220, when the SFP modules 210, 230 and the optical cable 220 are defective, data may not be normally transmitted or received between the electronic apparatus 100 and the display apparatus 300. Specifically, a part of the image data may be missing, and when the defect is severe, it may be impossible to transmit or receive image data between the electronic apparatus 100 and the display apparatus 300.

Thus, when the display apparatus 300 and the electronic apparatus 100 are connected through the optical cable 220, it entails a process of checking whether the optical cable 220 and the SFP modules 210, 230 are defective. However, defects in the SFP modules 210, 230 and the optical cable 220 may be discovered or may occur during the process of using the display apparatus 300. In other words, defects in the SFP modules 210, 230 and the optical cable 220 may not be detected at the time of initially connecting the display apparatus 300 and the electronic apparatus 100 through the optical cable 220, the SFP modules 210, 230 and the optical cable 220 were normal, but defects in the SFP modules 210, 230 and the optical cable 220 may be discovered later or a defect may occur in the SFP modules 210, 230 and the optical cable 220 that were normal. The above cases are due to various reasons such as high temperature or aging of the optical cable 220 caused by long-term use.

As a result, when the optical cable 220 or the SFP modules 210, 230 become defective in the process of using the display apparatus 300, the SFP modules 210, 230 and the optical cable 220 must be replaced. Therefore, time and cost are required separately. In particular, in the case of the large display apparatus 300 installed outdoors, the distance between the electronic apparatus 100 and the large display apparatus 300 is often far apart, so the length of the optical cable 220 used to connect the electronic apparatus 100 and the large display apparatus 300 is also very long. Therefore, in the case of the large display apparatus 300, it is costly and time-consuming to replace the optical cable 220.

In order to solve the above-described problem, the electronic apparatus 100 according to an embodiment proactively identifies the possibility of a defect in the SFP modules 210, 230 including the optical cable 220 before connecting the optical cable 220 between the electronic apparatus 100 and the display apparatus 300. Here, the possibility of a defect refers to a defect in the optical cable 220 and the SFP module that may occur in the future. In other words, the electronic apparatus 100 predicts whether a defect may occur due to high temperature, long-term use of the optical cable 220, and the like. Through this, the user may use the optical cable 220 and SFP modules 210, 230 with higher stability. Hereinafter, an embodiment of the present disclosure in this regard will be described in detail.

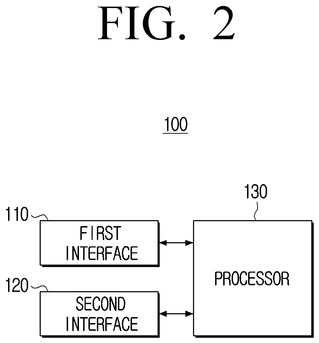

FIG. 2 is a schematic view illustrating the electronic apparatus 100 according to an embodiment.

The electronic apparatus 100 includes a first interface 110, a second interface 120, and one or more processors 130.

The first interface 110 is connected to a first small form-factor pluggable (SFP) module 210. The electronic apparatus 100 is connected to an end of the optical cable 220 through the first SFP module 210,

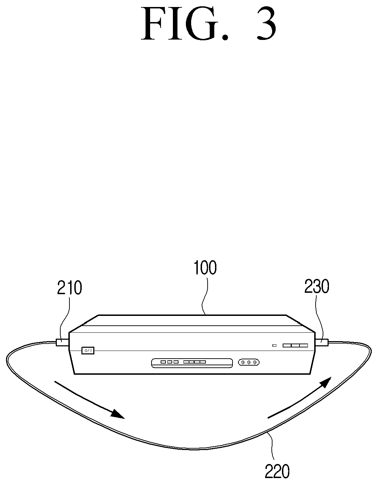

Referring to FIG. 3, the second interface 120 is connected to a second SFP module 230. The electronic apparatus 100 is connected to the other end of the optical cable 220 through the second SFP module 230. In other words, as one end of the optical cable 220 is connected to the first interface 110 (more specifically, one end of the optical cable 220 is connected through the first SFP module 210 connected to the first interface 110) and the other end of the optical cable 220 is connected to the second interface 120 (more specifically, one end of the optical cable 220 is connected through the second SFP module 230 connected to the second interface 120), the electronic apparatus 100 may form a closed-loop structure by the optical cable 220.

The one or more processors 130 control the overall operations and functions of the electronic apparatus 100. In particular, based on the closed loop structure of the electronic apparatus 100 and the optical cable 220, the one or more processors 130 may transmit image data through the first interface 110 and receive the transmitted image data back through the second interface 120.

Specifically, when the one or more processors 130 transmit a digital signal corresponding to the image data to the first SFP module 210 through the first interface 110, the first SFP module 210 transmits an optical signal corresponding to the received digital signal to the second SFP module 230 through the optical cable 220. The second SFP module 230 then converts the received optical signal into a digital signal and transmits the converted digital signal to the electronic apparatus 100 through the second interface 120. The one or more processors 130 may restore the image data based on the digital signal received from the second SFP module 230 through the second interface 120.

The one or more processors 130 may include one or more of a central processing unit (CPU), a graphics processing unit (GPU), an accelerated processing unit (APU), a many integrated core (MIC), a digital signal processor (DSP), a neural processing unit (NPU), a hardware accelerator, or a machine learning accelerator. The one or more processors 130 may control one or any combination of the other components of the electronic apparatus 100, and may perform communication-related operations or data processing. The one or more processors 130 may execute at least one program or instruction stored in the memory. For example, the one or more processors 130 may perform a method according to an embodiment by executing at least one instruction stored in the memory.

When a method according to an embodiment includes a plurality of operations, the plurality of operations may be performed by one processor 130 or by a plurality of processors 130. For example, when a first operation, a second operation, and a third operation are performed by the method according to an embodiment, all of the first operation, the second operation, and the third operation may be performed by the first processor 130, or the first operation and the second operation may be performed by the first processor (e.g., a general-purpose processor) and the third operation may be performed by the second processor (e.g., an artificial intelligence-dedicated processor).

The one or more processors 130 may be implemented as a single core processor including a single core, or as one or more multicore processors including a plurality of cores (e.g., homogeneous multicore or heterogeneous multicore). When the one or more processors 130 are implemented as a multicore processor, each of the plurality of cores included in the multicore processor may include internal memory of the processor, such as cache memory and an on-chip memory, and a common cache shared by the plurality of cores may be included in the multicore processor. Each of the plurality of cores (or some of the plurality of cores) included in the multi-core processor may independently read and perform program instructions to implement the method according to an embodiment, or all (or some) of the plurality of cores may be coupled to read and perform program instructions to implement the method according to an embodiment.

When a method according to an embodiment includes a plurality of operations, the plurality of operations may be performed by one core of a plurality of cores included in a multi-core processor, or may be performed by a plurality of cores. For example, when a first operation, a second operation, and a third operation are performed by a method according to an embodiment, all of the first operation, the second operation, and the third operation may be performed by the first core included in the multi-core processor, or the first operation and the second operation may be performed by the first core included in the multi-core processor and the third operation may be performed by the second core included in the multi-core processor.

In the embodiments of the present disclosure, the one or more processors 130 may mean a system-on-chip (SoC) in which one or more processors and other electronic components are integrated, a single-core processor, a multi-core processor, or a core included in a single-core processor or multi-core processor and here, the core may be implemented as CPU, GPU, APU, MIC, DSP, NPU, hardware accelerator, or machine learning accelerator, and the like, but the core is not limited to the embodiments of the present disclosure.

Hereinafter, the one or more processors 130 will be referred to as the processor 130 for convenience of explanation.

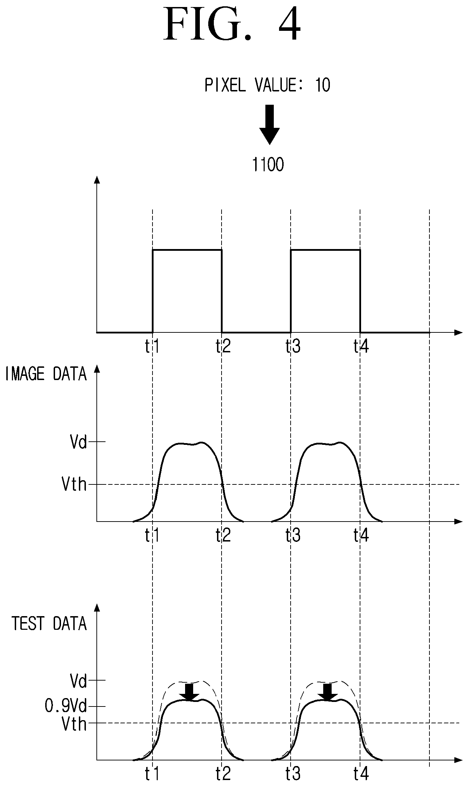

FIG. 4 is an exemplary view illustrating test data according to an embodiment.

According to an embodiment, the processor 130 changes the level of a voltage of image data to generate test data corresponding to the image data.

Here, the image data may be data corresponding to a pixel value for each pixel on a pixel array included in the display apparatus 300. The pixel value may correspond to a voltage applied to the pixel. Specifically, the display apparatus 300 may identify a pixel value corresponding to each pixel based on the image data received from the electronic apparatus 100, and may generate and provide to each pixel a voltage of the image data corresponding to the identified pixel value.

In particular, the display apparatus 300 (more specifically, the driver IC included in the display apparatus 300) may provide a gate signal for driving each pixel based on the image data or a data signal for providing an image data voltage (e.g., a constant current source data voltage or a PWM data voltage) provided to each pixel.

FIG. 4 illustrates image data provided to the display apparatus 300. According to an embodiment, when the pixel value for a specific pixel among a plurality of pixels included in the display apparatus 300 is '10', the image data corresponding to the specific pixel may be an analog signal corresponding to binary data corresponding to '10'. More specifically, when the pixel value is from 0 to 16, the binary data corresponding to the pixel value of '10', which is a pixel value corresponding to the specific pixel, is '1010'. In this case, the image data may represent the '1010' in the form of an analog signal.

In this case, the processor 130 adjusts the voltage level of the image data to generate test data corresponding to the image data. Here, the voltage level of the image data may be the size of the voltage of the image data. In other words, the processor 130 may generate the test data by adjusting the size of the voltage of the image data.

According to an embodiment, the processor 130 may generate the test data by decreasing the voltage level of the image data to a preset size. However, the present disclosure is not limited thereto, and the processor 130 may also generate the test data by increasing the voltage level of the image data to a preset size. However, hereinafter, for convenience of explanation, it is assumed that the test data is generated by decreasing the voltage level of the image data to a preset size.

For example, referring back to FIG. 4, the processor 130 may reduce the voltage level of the image data corresponding to the pixel value '10' by 10% to generate test data corresponding to the image data.

In this case, the voltage level applied to the image data voltage to generate the test data may be set according to the location and environment where the display apparatus 300 is installed. For example, the processor 130 may identify the temperature of the place where the display apparatus 300 is installed, and apply a voltage level corresponding to the identified temperature to the image data voltage. To this end, the memory of the electronic apparatus 100 may store a table including information on voltage levels applied according to temperature.

Alternatively, the processor 130 may apply different voltage levels depending on the expected usage period of the display apparatus 300. For example, the processor 130 may generate test data by adjusting the image data voltage to a higher voltage level as the expected usage period of the display apparatus 300 is longer.

Further, the processor 130 according to an embodiment may generate test data by changing the voltage level of the image data within a preset range. Specifically, the processor 130 may change the voltage level of the image data within a range above a preset threshold voltage.

According to an embodiment, referring to FIG. 4, when a preset threshold voltage is Vₜₕ, the processor 130 may adjust the voltage of the image data such that the level of the maximum voltage of the image data is equal to or greater than Vₜₕ. Specifically, as the voltage level of the image data corresponding to a '1' among the binary data corresponding to the pixel value changes, when the level of the changed voltage falls below Vₜₕ, the SFP module may identify the corresponding data as a '0'. Thus, the processor 130 may adjust the voltage level of the image data within a range in which the pixel value of each pixel remains unchanged.

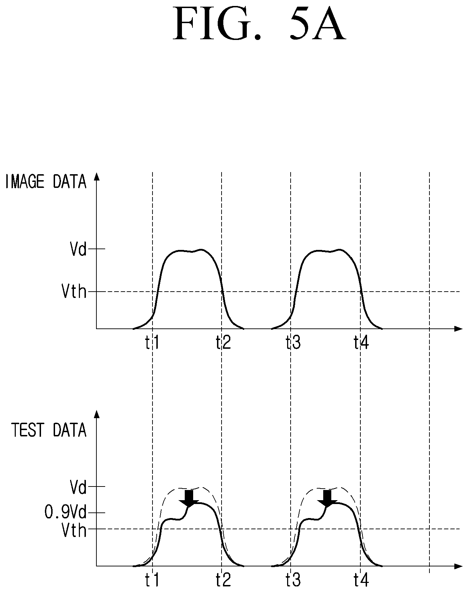

Meanwhile, according to an embodiment, the processor 130 may change the voltage of the image data based on a pre-emphasis method. Referring to FIG. 5A, the processor 130 may adjust the voltage of the image data corresponding to pixel value '8' according to the pre-emphasis method. Specifically, the processor 130 may adjust the initial voltage level of the voltage corresponding to the binary data '1' among the image data voltage. For example, the processor 130 may decrease the size of the initial voltage level of the voltage corresponding to the binary data '1' of the image data voltage by 10% to generate test data.

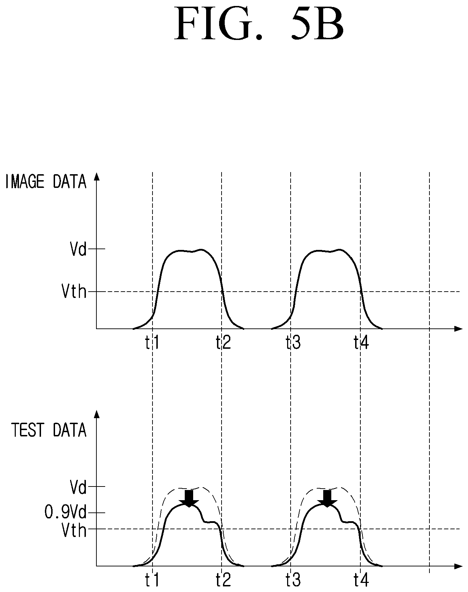

Further, according to an embodiment, the processor 130 may change the voltage of the image data based on a de-emphasis method. Referring to FIG. 5B, the processor 130 may adjust the voltage of the image data corresponding to pixel value '8' according to the de-emphasis method. Specifically, the processor 130 may adjust the terminal voltage level of the voltage corresponding to the binary data '1' among the image data voltage. For example, the processor 130 may reduce the size of the terminal voltage level of the voltage corresponding to the binary data '1' among the image data voltage by 10% to generate test data.

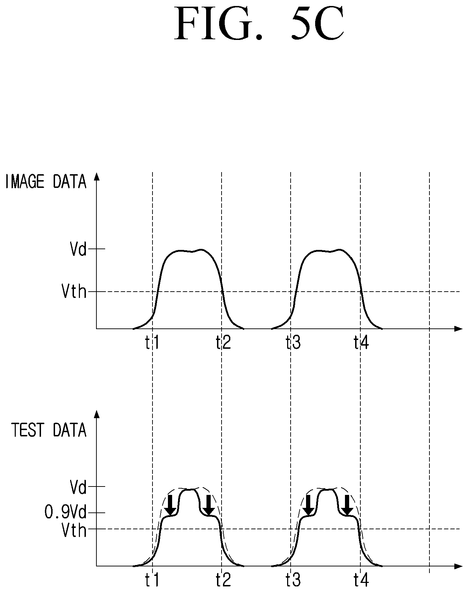

Meanwhile, according to an embodiment, the processor 130 may simultaneously apply a pre-emphasis method and a de-emphasis method to generate a test voltage. Referring to FIG. 5C, the processor 130 may adjust the initial voltage level and the terminal voltage level of the voltage corresponding to the binary data '1' among the image data voltage. Specifically, the processor 130 may reduce the size of each of the initial voltage level and the size of the late voltage level of the voltage corresponding to the binary data '1' among the image data voltage by 10% to generate test data.

When the test data transmitted through the first interface 110 is received through the second interface 120, the processor 130 identifies whether the optical cable 220 is progressively defective based on the received test data and the image data.

Here, the progressive defect refers to a defect of the optical cable 220 and the SFP modules 210, 230 that may occur in the future. In other words, the processor 130 may predict in advance a defect of the optical cable 220 and the SFP modules 210, 230 that may occur in various situations in the future, such as high temperature, long-term use of the SFP modules 210, 230 and the optical cable 220, and the like.

In particular, the level of the image data voltage received by the SFP modules 210, 230 may change due to high temperature, long-term use of the SFP modules 210, 230 and the optical cable 220, and the like. Therefore, the processor 130 may change the level of the image data voltage in advance to generate test data, and use the generated test data to predict a defect of the optical cable 220 and the SFP modules 210, 230 that may occur in the future.

Meanwhile, the processor 130 may generate verification data corresponding to the image data based on the image data, and may generate test data based on the generated verification data and the image data in which the level of the voltage is changed. Subsequently, the processor 130 may extract verification data from the received test data, and predict whether the optical cable 220 is defective based on the extracted verification data.

According to an embodiment, the processor 130 may generate verification data based on a plurality of pixel values included in the image data. For example, the processor 130 may generate verification data by summing a plurality of pixel values, identifying binary data corresponding to the plurality of pixel values, and generating an analog signal corresponding to the identified binary data. Subsequently, the processor 130 may generate test data including the generated verification data (hereinafter, referred to as first verification data) and the image data in which the voltage level adjusted.

Subsequently, the processor 130 may transmit the generated test data to the first SFP module 210 through the first interface 110 and then receive the test data from the second SFP module 230 through the second interface 120. The processor 130 may then extract verification data (hereinafter, referred to as second verification data) included in the received test data from and compare it with the first verification data generated prior to transmission, and when it is identified that the extracted second verification data matches the first verification data, identify that the SFP modules (i.e., the first SFP module 210 and the second SFP module 230) and the optical cable 220 are normal.

Alternatively, the processor 130 may store the generated first verification data in the memory of the electronic apparatus 100, and may adjust the level of the image data voltage to generate the test data. In this case, upon receiving the test data transmitted to the first SFP module 210 through the first interface 110 from the second SFP module 230 through the second interface 120, the processor 130 may generate the second verification data based on the received test data.

For example, when generating image data by summing a plurality of pixel values, the processor 130 may identify each pixel value based on the received test data, and generate the second verification data by summing the identified each pixel value. Subsequently, the processor 130 may identify whether the first verification data and the second verification data stored in the memory match, and when it is identified that the first verification data and the second verification data match, identify that the SFP modules (i.e., the first SFP module 210 and the second SFP module 230) and the optical cable 220 are normal.

Further, according to an embodiment, the processor 130 may change the level of the driving voltage of the SFP modules 210, 230, apply the changed driving voltage to the SFP modules, transmit the test data through the first interface 110, and receive the test data through the second interface 120 while the changed driving voltage is applied. Based on the received test data, the processor 130 may identify whether the SFP modules (i.e., the first SFP module 210 and the second SFP module 230) and the optical cable 220 are progressively defective.

Specifically, when the SFP modules (i.e., the first SFP module 210 and the second SFP module 230) are connected to each interface, the processor 130 may provide a driving voltage to the SFP modules 210, 230. In this case, the first SFP module 210 provided with the driving voltage from the electronic apparatus 100 may receive a digital signal corresponding to the image data from the electronic apparatus 100, and may generate an optical signal corresponding to the received digital signal (i.e., convert the received digital signal into an optical signal). Subsequently, the first SFP module 210 may transmit the optical signal to the second SFP module 230 through the optical cable 220. Meanwhile, the second SFP module 230 provided with the driving voltage from the electronic apparatus 100 may receive an optical signal from the first SFP module 210, convert the received optical signal into a digital signal, and transmit the converted digital signal to the electronic apparatus 100 through the second interface 120. In other words, the first and second SFP modules 210, 230 may operate based on the driving voltage provided by the electronic apparatus 100 after being connected to the first and second interfaces 110, 120 of the electronic apparatus 100, respectively.

After generating a test signal, the processor 130 may change the driving voltage level applied to the first SFP module 210 before transmitting the test data to the first SFP module 210 through the first interface 110. According to an embodiment, the processor 130 may reduce the driving voltage level applied to the first SFP module 210 by 10% before transmitting the test data to the first SFP module 210 through the first interface 110. In this case, the processor 130 may reduce the driving voltage level applied to the second SFP module 230 by 10%, as it did to the first SFP module 210. While the driving voltage level with the 10% reduced driving voltage level is being applied to the second SFP module 230, the processor 130 may receive an optical signal corresponding to the test data transmitted to the first SFP module 210 from the second SFP module 230 through the second interface 120. Subsequently, based on the received test data, the processor 130 may identify whether the SFP modules (i.e., the first SFP module 210 and the second SFP module 230) and the optical cable 220 are progressively defective. The method of identifying whether there is a progressive defect may be equally applicable as described above and thus, will not be described in detail.

As such, the processor 130 may adjust the level of driving voltage provided to the SFP modules 210, 230 and then transmit and receive the test data to detect a possible defect in the SFP modules and optical cable 220 in advance. For example, when the voltage efficiency of the SFP module decreases due to long-term use, the driving voltage in the SFP module may decrease even if the same driving voltage is applied to the electronic apparatus 100. Therefore, the processor 130 may adjust the level of driving voltage provided to the SFP module in advance to identify a defect that may occur in the case of long-term use of the SFP module.

Meanwhile, according to an embodiment, when the image data transmitted through the first interface 110 is received through the second interface 120, the processor 130 may identify whether the optical cable 220 is defective based on the image data and, when it is identified that the optical cable 220 is normal, may generate test data.

Specifically, the processor 130 may identify whether the SFP modules and optical cable 220 are progressively defective based on the test data after identifying whether there is a defect that can be currently discovered in the SFP modules and the optical cable 220, rather than a progressive defect that may occur in the future. To this end, the processor 130 may transmit the image data to the first SFP module 210 through the first interface 110, receive the image data from the second SFP module 230 through the second interface 120, and then identify whether there is a defect based on the received image data.

In other words, when it is identified that the transmitted image data and the received image data match, the processor 130 may identify that the SFP modules 210, 230 and the optical cable 220 are normal. Specifically, the processor 130 may transmit data combining digital data corresponding to the image data and digital data generated based on pixel values of a plurality of pixels constituting an image based on the image data (for example, binary data corresponding to the sum of pixel values of the plurality of pixels) to the first SFP module 210 through the first interface 110, and may receive data transmitted from the second SFP module 210 through the second interface 110 (i.e., data combining digital data corresponding to the image data and digital data generated based on pixel values of a plurality of pixels). In this case, the processor 130 may extract data corresponding to the digital data generated based on the pixel values of the plurality of pixels included in the received data and compare it with verification data included in the transmitted data (i.e., digital data generated based on the pixel values of the plurality of pixels). Subsequently, when the extracted data and the verification data match, the processor 130 may identify that the SFP modules 210, 230 and the optical cable 220 are normal. On the other hand, when the extracted data and the verification data match, the processor 130 may identify that the SFP modules 210, 230 and the optical cable 220 are defective.

Subsequently, when it is identified that the SFP modules 210, 230 and optical cable 220 are normal, the processor 130 may adjust the level of the image data voltage to generate test data.

Meanwhile, according to an embodiment, the processor 130 may stepwise perform the process of identifying a defect using image data, the process of identifying a defect using test data, and the process of identifying a defect by adjusting a driving voltage level. For example, the processor 130 may first identify whether there is a defect using image data (step 1) and then, when it is identified that the SFP modules 210, 230 and the optical cable 220 are normal based on the image data, adjust the voltage level of the image data to generate test data, and identify whether there is a defect using the test data (step 2). Subsequently, when it is identified that the SFP modules 210, 230 and the optical cable 220 are normal based on the test data, the processor 130 may adjust the driving voltage level of the SFP modules 210, 230 to identify whether there is a defect (step 3). Meanwhile, in the step 2, the processor may first generate a test voltage by reducing the voltage of the image data collectively to identify whether there is a defect (step 2-1), generate a test voltage by reducing the voltage of the image data based on the pre-emphasis method to identify whether there is a defect (step 2-2), and then generate a test voltage by reducing the voltage of the image data based on the de-emphasis method to identify whether there is a defect (step 2-3).

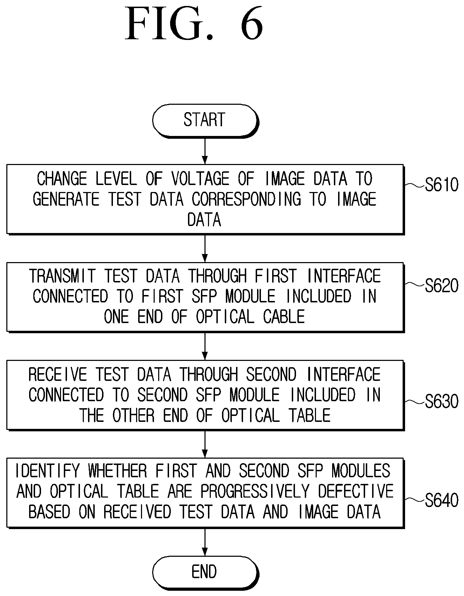

**FIG.** 6 is an exemplary view schematically illustrating a controlling method of an electronic apparatus according to an embodiment.

When the method of controlling the electronic apparatus 100 is performed by the processor 130 according to an embodiment, the processor 130 first changes the voltage level of the image data to generate test data corresponding to the image data (S610).

In this case, the processor 130 may change the voltage of the image data based on at least one of a pre-emphasis method or a de-emphasis method.

In addition, the processor 130 may generate test data by reducing the voltage level of the image data to a preset size.

Further, the processor 130 may generate test data by changing the voltage of the image data within a preset range.

Meanwhile, after generating the test data, the processor 130 transmits the test data through the first interface 110 connected to the first small form-factor pluggable (SFP) module included in one end of the optical cable 220 (S620).

Subsequently, the processor 130 receives the test data through the second interface 120 connected to the second SFP module 230 included in the other end of the optical cable 220 (S630) .

Meanwhile, in step S620, the processor 130 may change the level of the driving voltage of the SFP module to apply the changed voltage to the first and second SFP modules 210, 230, and may transmit the test data through the first interface 110. Subsequently, the processor 130 may receive the test data through the second interface 120 while the driving voltage changed in step S630 is applied to the first and second SFP modules 210, 230.

Meanwhile, the processor 130 identifies whether the optical cable 220 is progressively defective based on the received test data and the image data (S640).

Specifically, the processor 130 may generate verification data corresponding to the image data based on the image data. In this case, the test data may further include the verification data along with the image data with the changed level. Meanwhile, upon receiving the test data from the second SFP module 230 through the second interface 120, the processor 130 may identify whether the optical cable 220 is defective based on the pre-generated verification data.

Meanwhile, prior to step S601, the processor 130 may receive the image data transmitted through the first interface 110 through the second interface 120, and may identify whether the optical cable 220 is defective based on the image data. Subsequently, when it is identified that the optical cable 220 is normal the processor 130 may generate test data.

Meanwhile**,** the methods according to the various embodiments described above may be implemented in the form of an application that can be installed in an existing electronic apparatus. Alternatively, the methods according to the various embodiments described above may be performed using a deep learning-based artificial neural network (or deep artificial neural network), i.e., a learning network model. In addition, the methods according to the various embodiments of the present disclosure described above may be implemented only with a software upgrade or a hardware upgrade for an existing electronic apparatus. Further, the various embodiments of the present disclosure described above may also be performed through an embedded server provided in the electronic apparatus or an external server of the electronic apparatus.

Meanwhile, according to an embodiment, the above-described various embodiments may be implemented as software including instructions stored in machine-readable storage media, which can be read by machine (e.g.: computer). The machine refers to a apparatus that calls instructions stored in a storage medium, and can operate according to the called instructions, and the apparatus may include a display apparatus (e.g., display apparatus A) according to the aforementioned embodiments. In case an instruction is executed by a processor, the processor may perform a function corresponding to the instruction by itself, or by using other components under its control. The instruction may include a code that is generated or executed by a compiler or an interpreter. The machine-readable storage medium may be provided in the form of a non-transitory storage medium. Here, the term 'non-transitory' means that the storage medium is tangible without including a signal, and does not distinguish whether data are semi-permanently or temporarily stored in the storage medium.

In addition, according to an embodiment, the above-described methods according to the various embodiments may be included and provided in a computer program product. The computer program product may be traded as a product between a seller and a purchaser. The computer program product may be distributed in a form of a storage medium (e.g., a compact disc read only memory (CD-ROM)) that may be read by the machine or online through an application store (e.g., PlayStore^{™}). In case of the online distribution, at least a portion of the computer program product may be at least temporarily stored in a storage medium such as a memory of a server of a manufacturer, a server of an application store, or a relay server or be temporarily generated.

Further, the components (e.g., modules or programs) according to various embodiments described above may include a single entity or a plurality of entities, and some of the corresponding sub-components described above may be omitted or other sub-components may be further included in the various embodiments. Alternatively or additionally, some components (e.g., modules or programs) may be integrated into one entity and perform the same or similar functions performed by each corresponding component prior to integration. Operations performed by the modules, the programs, or the other components according to the various embodiments may be executed in a sequential manner, a parallel manner, an iterative manner, or a heuristic manner, or at least some of the operations may be performed in a different order or be omitted, or other operations may be added.

Although preferred embodiments of the present disclosure have been shown and described above, the disclosure is not limited to the specific embodiments described above, and various modifications may be made by one of ordinary skill in the art without departing from the gist of the disclosure as claimed in the claims, and such modifications are not to be understood in isolation from the technical ideas or prospect of the disclosure.

## Claims

1. An electronic apparatus comprising:
a first interface connected to a first small form-factor pluggable (SFP) module included in one end of an optical cable;
a second interface connected to a second SFP module included in the other end of the optical cable; and
one or more processors configured to:
change a level of a voltage of image data to generate test data corresponding to the image data; and
based on the test data transmitted through the first interface being received through the second interface, identify whether the first and second SFP modules and the optical cable are progressively defective based on the received test data and the image data.

2. The apparatus as claimed in claim 1,wherein the one or more processors are configured to:
generate verification data corresponding to the image data based on the image data, and
generate the test data based on the generated verification data and the image data in which the level of the voltage is changed; and
extract the verification data from the received test data, and identify whether the first and second SFP modules and the optical cable are progressively defective based on the extracted verification data.

3. The apparatus as claimed in claim 1, wherein the one or more processors are configured to change a voltage of the image data based on a pre-emphasis method.

4. The apparatus as claimed in claim 1, wherein the one or more processors are configured to change a voltage of the image data based on a de-emphasis method.

5. The apparatus as claimed in claim 1, wherein the one or more processors are configured to change a level of a driving voltage of the SFP module and apply the changed driving voltage to the first and second SFP modules, transmit the test data through the first interface, and receive the test data through the second interface while the changed driving voltage is applied to the first and second SFP modules.

6. The apparatus as claimed in claim 1, wherein the one or more processors are configured to, based on the image data transmitted through the first interface being received through the second interface, identify whether the optical cable is defective based on the image data, and based on the optical cable being identified as normal, generate the test data.

7. The apparatus as claimed in claim 1, wherein the one or more processors are configured to generate the test data by reducing a level of a voltage of the image data to a preset size.

8. The apparatus as claimed in claim 1, wherein the one or more processors are configured to generate the test data by changing a level of a voltage of the image data within a preset range.

9. A controlling method of an electronic apparatus, the method comprising:
changing a level of a voltage of image data to generate test data corresponding to the image data;
transmitting the test data through a first interface connected to a first small form-factor pluggable (SFP) module included in one end of an optical cable;
receiving the test data through a second interface connected to a second SFP module included in the other end of the optical cable; and
identifying whether the first and second SFP modules and the optical cable are progressively defective based on the received test data and the image data.

10. The method as claimed in claim 9, wherein the generating comprises:
generating verification data corresponding to the image data based on the image data; and
generating the test data based on the generated verification data and the image data in which the level of the voltage is changed; and
wherein the identifying comprises identifying whether the first and second SFP modules and the optical cable are progressively defective based on the verification data.

11. The method as claimed in claim 9, wherein the generating comprises changing a voltage of the image data based on a pre-emphasis method.

12. The method as claimed in claim 9, wherein the generating comprises changing a voltage of the image data based on a de-emphasis method.

13. The method as claimed in claim 9, wherein the transmitting comprises:
changing a level of a driving voltage of the SFP module and apply the changed driving voltage to the first and second SFP modules, and transmitting the test data through the first interface; and
wherein the receiving comprises receiving the test data through the second interface while the changed driving voltage is applied to the first and second SFP modules.

14. The method as claimed in claim 9, comprising:
receiving the image data transmitted through the first interface through the second interface; and
identifying whether the optical cable is defective based on the image data,
wherein the generating comprises, based on the optical cable being identified as normal, generating the test data.

15. A non-transitory computer-readable recording medium storing a computer instruction that, when executed by a processor of an electronic apparatus, causes the electronic apparatus to:
change a level of a voltage of image data to generate test data corresponding to the image data;
transmit the test data through a first interface connected to a first small form-factor pluggable (SFP) module included in one end of an optical cable;
receive the test data through a second interface connected to a second SFP module included in the other end of the optical cable; and
identify whether the first and second SFP modules and the optical cable are progressively defective based on the received test data and the image data.
